# EUROPEAN PATENT APPLICATION

(11) **EP 2 428 961 A1**
(43) Date of publication of application: **14.03.2012**
(21) Application number: 11181053.7
(22) Date of filing: 13.09.2011
(51) Int. Cl.: G11C 11/419, G11C 11/413

(54) **Method for improving writability of SRAM memory**

(30) Priority: 13.09.2010 US 382243 P
(71) Applicant: IMEC, 3001 Leuven (BE); Katholieke Universiteit Leuven, K.U. Leuven R&D, 3000 Leuven (BE); Stichting IMEC Nederland, 5656 AE Eindhoven (NL)
(72) Inventor: Sharma, Vibhu, 3001 Leuven (BE); Cosemans, Stefan, 2400 Mol (BE); Dehaene, Wim, 3010 Kessel-Lo (BE); Catthoor, Francky, 9140 Temse (BE); Ashouei, Maryam, 5611 HX Eindhoven (NL); Huisken, Jos, 5583 GV Waalre (NL)
(74) Representative: Sarlet, Steven Renaat Irène

(57) **Abstract**

Disclosed is a method for improving writability of an SRAM cell, by applying a first voltage (VSS+Δv1) higher than the global ground voltage (VSS) and a third voltage (VDD+Δv3) higher the global supply voltage (VDD) to the ground resp supply nodes of the invertors of the SRAM cell, and by pre-charging one of the complementary bitlines (WBL, WBL\) to the global ground voltage (VSS), and by applying a second voltage (VDD+Δv2) higher than the global supply voltage (VDD) to the access transistors (Mpl, Mpr) during a write operation to the SRAM cell.

## Description

### TECHNICAL FIELD

The invention relates to a method for writing a value in an SRAM (static random access memory) cell. More in particular the invention relates to a technique for improving the writability of SRAM memory cells, in particular 6T and 8T SRAM cells. The invention also relates to an SRAM memory adapted for using this method, and to an electronic device comprising such an SRAM memory.

### BACKGROUND ART

The usage of SRAM is continuously increasing in system-on-chip (SOC) designs. Process technology scaling has contributed remarkably in improving the performance of and area density of system-on-chip, whereby the SRAM cell typically utilizes the minimum sized transistor in order to realize a high density. However, SRAM scaling has become extremely difficult in the advanced technology nodes (e.g. 65 or 32 nm Low Power CMOS technology).

SRAM bit cell functional parameter degradation due to increasing variability and decreasing power supply is of utmost concern. One of the problems is writability, causing write-failures in the SRAM cell. A failure to write occurs when the access transistor is not strong enough to overpower the pull-up PMOS and pull the internal node to ground.

Several write assist techniques to improve writability at low supply voltages are described in the art, the two most important techniques being Boosted Word-line (BWL) [1] and Negative Bit Line (NBL) [2]. The word line boosting scheme (BWL) relative to VDD of SRAM cells reduces the stability (SNM_{READ}) of the half selected SRAM cells on the same word line, which puts a higher limit on the value of word line boosting applied. The negative bit-line technique (NBL) requires the VSS side of the bit-line to be negative biased. This increases the risk of forward biasing PN Junctions (latch-up) and puts the limit on the value of an applied negative boost.

### DISCLOSURE OF THE INVENTION

It is an aim of the present invention to provide an alternative technique for improving the writability of an SRAM cell.

Improving writability means decreasing the risk of write failures.

This aim is achieved according to the present invention by a method having the characteristics of the first claim.

Thereto the present invention provides a method for writing a bit-value in at least one SRAM cell, part of an SRAM memory, the SRAM cell comprising a pair of cross-coupled invertors for storing the bit-value, the invertors being connected between a local ground node and a local supply node, each invertor being connected via its input to one of a pair of complementary bitlines via one of a pair of access transistors for writing the bit-value in the SRAM cell, the pair of access transistors being controllable by a write_wordline, the method comprising the step of:
a) applying a global supply voltage and a global ground voltage to the SRAM memory;
b) pre-charging one of the bitlines of the pair of complementary bitlines to the global ground voltage, and pre-charging the other bitline of the pair of complementary bitlines to a complementary voltage, depending on the bit-value to be written in the SRAM cell;
c) providing a first voltage to said local ground node, the first voltage having a value higher than the value of the global ground voltage by a first predefined amount;
d) applying a second voltage to the write_wordline, the second voltage having a value higher than the value of the global supply voltage by a second predefined amount;
e) applying a third voltage to said local supply node, the third voltage having a value higher than the value of the global supply voltage by a third predefined amount.

With complementary voltage is meant a "high" voltage, complementary to the "low" voltage.

Applying the first voltage higher than the global ground voltage to said ground node reduces the strength of the aids in overpowering the state of the cell, which improves write-ability. Applying the second voltage higher than the value of the global supply voltage to the write-word line increases the strength of the access transistors, which further improves write-ability. Applying the third voltage to said local supply node solves the problem of "half select" cells located on the same row of the SRAM cell to be written (i.e. SRAM cells sharing the same write-wordline), and solves data retention issues with the SRAM cells present on the same column (i.e. sharing the same pair of bitlines), due to the raised ground voltage.

Although similar in many respects to the negative bitline technique of the prior art, an important advantage of the method of the present invention is that it can avoid the risk of forward biasing PN junctions (latch-up), which puts a limit on the value of the applied negative "boost" (i.e. the difference between the negative voltage applied to the bitline and the ground voltage). This risk can be avoided because in the method of the present invention the voltage with the lowest value, i.e. the global ground voltage is preferably applied as the bulk voltage of the SRAM memory.

Preferably, the first amount is equal to or higher than the third amount and the second amount is equal to or higher than the third amount. This can further improve the writability of the cell.

Preferably the first and second and third amount are substantially equal. This offers the advantage that writability is improved while readability is not degraded. In addition, using the same voltage for the write_wordline and for the local supply voltage (during a write cycle) has the advantage of requiring less different voltages.

Preferably the SRAM cells are grouped in SRAM words, and the SRAM words are arranged in rows of SRAM cells sharing the write_wordline, and in columns of SRAM cells sharing the pair of bitlines, and wherein the first voltage is applied only to the column, and the second and third voltage are applied only to the row containing the SRAM word which is to be written, and preferably only when actually being written.

By providing the increased voltages only to the column and row containing the SRAM word being written, and not to the entire SRAM memory, the integrity of the other SRAM cells is maximally secured, and energy can be saved. By applying the increased voltages to the entire column and row containing the SRAM word being written, and not to the single SRAM word to be written, huge selection overhead can be saved.

The invention also provides an SRAM memory comprising:
- a plurality of SRAM cells, each SRAM cell comprising a pair of cross-coupled invertors for storing a bit-value, the invertors being connected between a local ground node and a local supply node, each invertor being connected via its input to one of a pair of complementary bitlines via one of a pair of access transistors for writing the bit-value in the SRAM cell, the pair of access transistors being controllable by a write_wordline;
- source voltage applying means for applying a global ground voltage and a global supply voltage to the SRAM memory;
- precharging means for precharging one of the bitlines of the pair of complementary bitlines of the SRAM cell to the global ground voltage, and for precharging the other bitline of the pair of complementary bitlines to a complementary voltage, depending on the bit-value to be written in the SRAM cell;
- first means for applying a first voltage to said local ground node, the first voltage having a value higher than the value of the global ground voltage by a first predefined amount;
- second means for applying a second voltage to said write_wordline for enabling its pair of access transistors, the second voltage having a value higher than the value of the global supply voltage by a second predefined amount;
- third means for applying a third voltage to said local supply node, the third voltage having a value higher than the value of the global supply voltageby a third predefined amount.

Such an SRAM memory can be used for implementing the above method.

Preferably, the first amount is equal to or higher than the third amount and the second amount is equal to or higher than the third amount.

Preferably the first means comprise first switching means for disconnecting the local ground node of said SRAM cell from the global ground voltage and for connecting the local ground node to a first voltage node to which the first voltage value is applied;
- the second means comprise second switching means for connecting the write_wordline of the SRAM cell to a second voltage node to which the second voltage value is applied;
- the third means are third switching means for disconnecting the local supply node of said SRAM cell from the global supply voltage and for connecting said local supply node to a third voltage node to which the third voltage value is applied.

Preferably the SRAM further comprises control circuitry adapted for generating control signals for controlling the first and second and third switching means, such that during a write cycle to said SRAM cell, the local ground node is connected to the first voltage node, the write_wordline is connected to the second voltage node, and the local supply node is connected to the third voltage node.

Said increased voltages may be applied by such first, second and third switching means connected to the local ground nodes, write_wordlines and the local supply nodes of the SRAM memory.

Preferably the SRAM cells are grouped in SRAM words, and the SRAM words are arranged in rows of SRAM cells sharing the write_wordline and in columns of SRAM cells sharing the pair of complementary bitlines and sharing the local ground node, and wherein the first switching means is adapted for applying the first voltage to the column, and the second switching means is adapted for applying the second voltage to the row of the SRAM word to be written, and the third switching means is adapted for applying the third voltage to the row and/or column of the SRAM word to be written.

By providing a structure having local ground nodes that can be switched at column level, and having local supply nodes that can be switched at row level, as opposed to switching each SRAM cell individually, large area savings can be achieved, without wasting too much energy. By switching the local ground and local supply voltages instead of switching the global ground and global supply voltages, and by switching them only during a write cycle, huge energy savings can be achieved.

Preferably the second voltage node is the same as the third voltage node. This offers placement (area, layout, routing) advantages in that the SRAM cell only needs one "high voltage node", and (as will be shown further) the stability of unselected cells is improved, and in that less different voltages need to be supplied.

The invention also relates to an electronic device comprising such an SRAM memory.

### BRIEF DESCRIPTION OF THE DRAWINGS

The invention is further elucidated in the appending figures and figure description explaining preferred embodiments of the invention. Note that the figures are not necessarily drawn to the scale. The figures are intended to describe the principles of the invention.
Fig 1 shows a circuit diagram of a 6T SRAM cell.
Fig 2 shows the structure of Fig 1 in more detail.
Fig 3 shows a circuit diagram of an 8T SRAM cell.
Fig 4 shows a write cycle performed on the 6T SRAM cell of Fig 2, and illustrates how Vt mismatch may cause write failures.
Fig 5 shows the principle of the negative bitline technique known in the art.
Fig 6 shows a preferred embodiment of the mimicked negative bitline MNBL technique, which is a preferred embodiment of the present invention.
Fig 7 shows a high-level block diagram of an embodiment of the SRAM memory according to the present invention.
Fig 8 shows the SRAM array of Fig 7 in idle state (no write action).
Fig 9 shows the SRAM array of Fig 7 during a write operation to the selected SRAM word.
Fig 10 shows the voltages applied to the different zones of the SRAM memory of Fig 9.
Figures 11A and 11B show the effect of increasing the local ground voltage, Fig 11A for an SRAM cell to be written, Fig 11B for an inactivated SRAM cell in the same column as the selected SRAM cell.
Figures 12A and 12B show the effect of increasing the local ground voltage and the write_wordline voltage, in Fig 12A for an SRAM cell to be written, in Fig 12B for an inactivated SRAM cell in the same row.
Figures 13A and 13B show the effect of subsequently increasing the local supply voltage, in Fig 13A for an SRAM cell to be written, in Fig 13B for an inactivated SRAM cell in the same row.
Fig 14 shows plots of the write margin for different values of Δv1, Δv2 and Δv3, for supply voltage VDD= 0.55V in 65nm LP technology.
Fig 15 shows plots of the static noise margin SNM Read for different values of Δv1, Δv2, Δv3, for supply voltage VDD= 0.55V in 65nm LP technology.
Fig 16 shows a comparison of the performance of the mimicked negative bitline technique (MNBL) versus the Negative Bitline technique (NBL).
Figures 17A, 17B, 17C show an example of the first, second and third switching means.
Fig 18 shows the improvement of the write margin obtained by the preferred embodiment of the MNBL technique for a predefined amount of 0.10 V.

### DETAILED DESCRIPTION OF PREFERRED EMBODIMENTS

### REFERENCES

- BL: bitline
- BL\: bitline bar (complement of BL)
- BWL: boosted word-line technique
- ΔV: difference voltage
- H: high value
- INV1: first invertor
- INV2: second invertor
- L: low value
- MNBL: mimicked negative bitline technique
- Mul: left pull-up transistor
- Mur: right pull-up transistor
- Mdl: left pull-down transistor
- Mdr: right pull-down transistor
- Mpl: left pass (or write access) transistor
- Mpr: right pass (or write access) transistor
- NBL: negative bitline technique
- Q: output voltage of the first invertor
- Q\: output voltage of the second invertor
- RBL: read bitline
- RWL: read word-line
- VDD: supply voltage
- VDD_high: voltage higher than supply voltage
- VSS: ground voltage
- VSS_high: voltage higher than ground voltage
- WWL: write word-line
- WBL: write bitline
- WBL\: write bitline-bar (complement of WBL)
- Z1-Z4: zone 1 to zone 4

The present invention will be described with respect to particular embodiments and with reference to certain drawings but the invention is not limited thereto. The drawings described are only schematic and are nonlimiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting of only components A and B. It means that with respect to the present invention, the only relevant components of the device are A and B.

The present invention relates to static random access memory (SRAM). In particular, the present invention discloses a technique for improving the writability of SRAM cells for advanced technology nodes (65 nm LP CMOS and beyond).

In the past, process technology scaling has contributed remarkably in improving the performance of and area density of system-on-chip (SoC) in general, and SRAM in particular. But the SRAM scaling has become extremely difficult in the advanced technology nodes (65nm LP CMOS and beyond). This is mainly because of the fact that, in order to realize the high density, the SRAM cell utilizes the minimum sized transistor which is highly susceptible to Vt (threshold voltage) mismatches. The Vt mismatch is mainly caused by a do-pant-ion implantation variation and gate edge roughness and is inversely proportional to the transistor size. SRAM bit cell functional parameter degradation due to increasing variability and decreasing power supply is of utmost concern. The process variations are classified into two categories one which result in the differences in the characteristics of the neighboring devices on the same die (intra die) and the other which effects all the devices on a die in the same manner (inter die). The intra die variations are in inverse proportion to the square root of the transistor channel area. With the technology scaling the shrinking transistor dimensions result in large intra die variations which degrade the read current I_{READ}, the read static noise margin SNM_{READ} and the write margin of the SRAM cell. The classic design approach in order to meet the challenges posed by the technology scaling relies on the upsizing and on the extra design margins. This upsizing and too much insertion of the design margins result in a degradation of energy consumption and performance. Therefore, circuit design techniques which improve the operating margins of SRAM without increasing the energy consumption are required. The present invention focuses on improving the write margin of an SRAM cell.

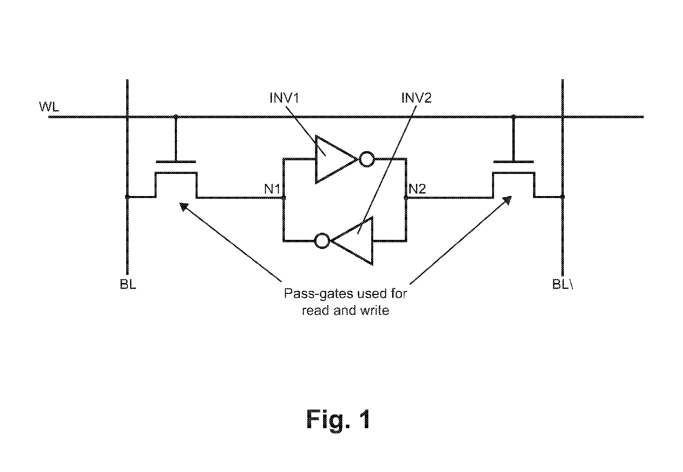

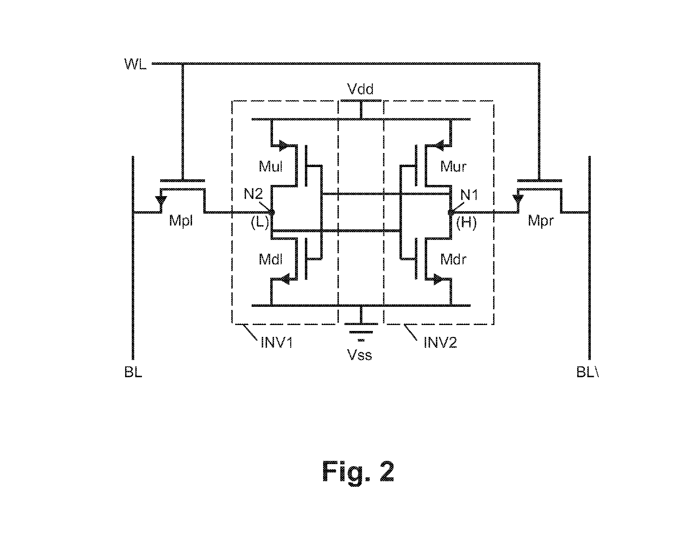

In order to better understand the present invention, first a 6T SRAM will be described, as shown in Figs 1 and 2.

Fig 1 shows a block diagram of a traditional 6T SRAM cell. Fig 2 shows the structure of Fig 1 in more detail. Each SRAM cell includes a pair of inverters INV1, INV2 that are cross-coupled (i.e. the input of one invertor is connected to the output of the other invertor) for operating together in a loop to store true and complement data Q, Q\ on the nodes N1, N2. The local true bitline BL and the local complement bitline BL\ are connected to the SRAM cell by a pair of access transistors Mpl, Mpr to respective true and complement sides of the invertors. The bitlines BL, BL\ are typically grouped in bit slices (not shown) of a multiple of SRAM cells. A wordline WL provides the gate input to the access transistors Mpl, Mpr. A particular wordline WL is activated (also called "enabled") for turning on the access transistors of the selected SRAM cell to perform a read or write operation. Associated with each bit slice are pre-charge true and complement circuits coupled to the respective local true and complement bitlines BL and BL\, write true and write complement circuits, and a local evaluate circuit (not shown). Since true and complement data is stored in the SRAM memory cell, either the pre-charged high true local bitline BL will be discharged if a "zero" was stored on the true side, or the pre-charged high complement bitline BL\ will be discharged if a "zero" was stored on the complement side. The local bitline BL or BL\ connected to the "one" side will remain in its high pre-charged state during a write access.

Fig 2 shows the six individual transistors (hence 6T) of the standard 6T SRAM cell of Fig 1: a left and right access transistor Mpl, Mpr, a left pull-up PMOS transistor Mul and a left pull-down NMOS transistor Mdl forming the first invertor INV1, a right pull-up PMOS transistor Mur and a right pull-down NMOS transistor Mdr forming the second invertor INV2. The input N1 of the first inventor INV1 is coupled with the output of the second invertor INV2, and vice versa. In this way they form a loop which stores the data. In fact they store two complementary values, in this example a high voltage value H on the right side, and a low voltage value L on the left side.

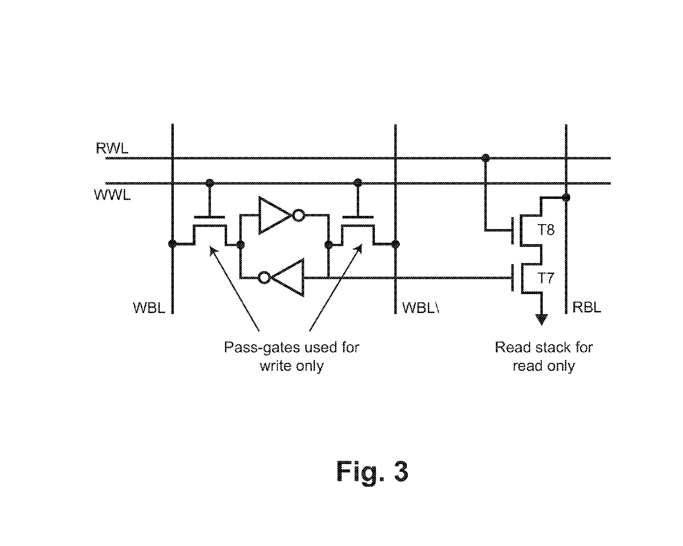

Fig 3 shows a block diagram of a traditional 8T SRAM cell. Comparison of the 8T SRAM cell with the 6T SRAM cell of Fig 2 shows that a read port is added comprising two additional transistors T7, T8, a read bitline RBL is added and a read_wordline RWL is added. Note that the read_ and write_wordline RWL, WWL, and the read_ and write_bitlines RBL, WBL, WBL\ are completely separate. As known in the art, this provides a solution to readability problems of the SRAM cell, at the expense of increased area, but does this not solve the writability problem of the 6T SRAM cell, which is an aim of the present invention.

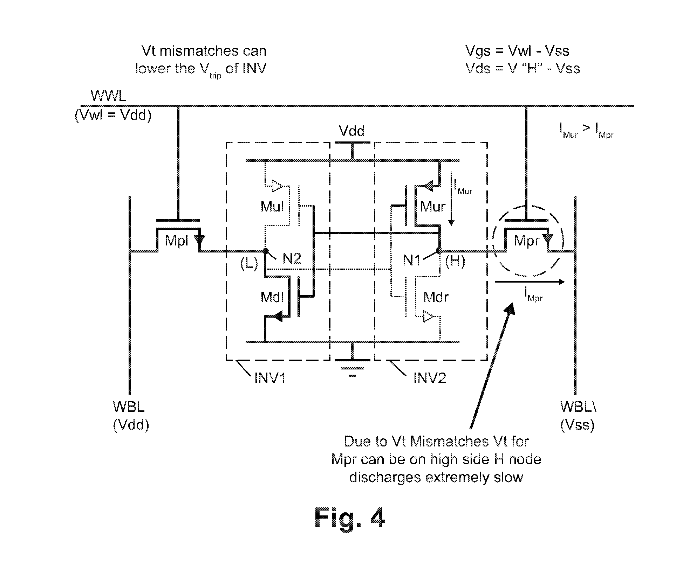

Fig 4 shows a write operation of the standard 6T SRAM cell initially storing a high value H at the right node N1 and a low value L in the left node N2. To change the value in the SRAM cell, i.e. to write a high value H at the left node N2, (and a low value in the right node N1), the voltage at the right node N1, i.e. the input of the first invertor INV1 needs to be pulled below the trip point of the first inverter INV1 that drives the left node N2. This should occur when the write_wordline WWL is asserted by applying voltage Vwl equal to VDD to the access transistors Mpl, Mpr, the word_bitline WBL being pre-charged to the supply voltage VDD, the complementory word_bitline WBL\ being pre-charged to ground VSS. If everything works fine, a discharge current IMur will then flow through the right pull-up transistor Mur and through the right access transistor Mpr to the complementary write_bitline WBL\, causing the voltage of node N1 to drop below the trip point of the first invertor INV1, causing the voltage at the left node N2 to go high, which in turn causes the value of the second invertor INV2 to go low.

However, an increased strength of the right pull-up transistor Mur or a decreased strength of the right access transistor Mpr due to process variations can impede the discharge process through the right access transistor Mpr. Furthermore, process variations may also reduce the trip point of the first inverter INV1 resulting in a write failure. For a successful write operation, the current IMpr through the right access transistor Mpr should be higher than the current IMur through the right pull-up transistor Mur. The write margin, abbreviated WM, is determined by the current ratio of the pull-up PMOS transistors Mul, Mur in relation to the pass access NMOS transistors Mpl, Mpr. A successful write operation can be achieved by increasing the strength of the write access NMOS pass transistors Mpl, Mpr or by decreasing the strength of the pull-up PMOS transistors Mul, Mur, or both.

The techniques that have been proposed in the art for improving the write margin WM can broadly be classified into two categories, a first category of techniques which target increasing the strength of write NMOS access like WL-boosting [1] and Negative Bitline boosting [2], and a second category of technique which target decreasing the strength of the latch structure like lowering the supply voltage VDD [3] and raising the ground voltage VSS [4]. Increasing the strength of the write NMOS access transistors Mpr, Mpl is more effective for improving the write margin WM of an SRAM cell than reducing the strength of the latch structure.

Increasing the voltage level of the write_wordline WWL relative to VDD power supply of the SRAM cell, a technique known as "wordline boost" increases the strength of the NMOS write access transistors Mpr, Mpl for avoiding the write failure. However, the "word line boosting" technique reduces the stability (SNM_{READ}) of the half selected SRAM cells on the same word line WL. Half selected SRAM cells are cells not being written to, but sharing an asserted wordline WL with other SRAM cells being written to. The reduced static noise margin SNM_{READ} for the half selected SRAM cells on the same word line WL puts a higher limit on the value of word line boosting applied.

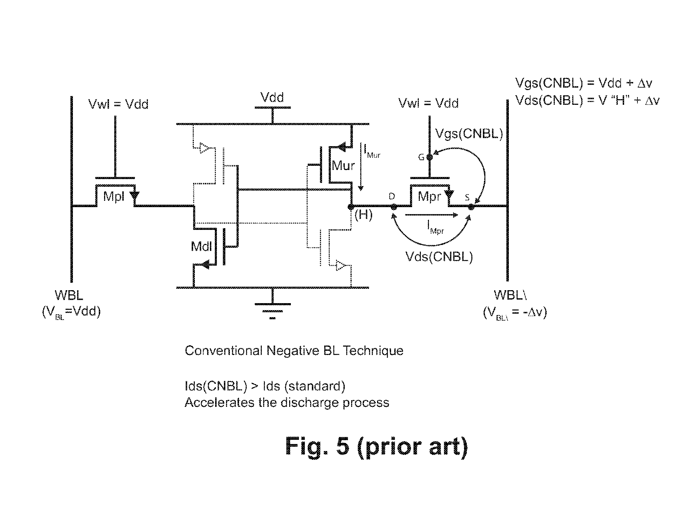

Fig 5 illustrates a technique known as "negative bitline", abbreviated "NBL", where the strength of the write access transistor Mpr is increased by lowering the voltage of the write_bitline WBL\ to a negative voltage (i.e. a voltage below the ground VSS). This increases the gate-to-source voltage V_{GS} and the drain-to-source voltage V_{DS} of the pass transistor Mpr. This accelerates the discharge process and the write failure is avoided. The negative bitline bias does not directly impact the half select bits. Although the write_bitlines WBL, WBL\ are typically shared between several SRAM cells, there is no problem for the unselected SRAM cells because the write_wordlines WWL for those unselected cells are at the ground voltage VSS, and thus not activated. The increase in the gate-to-source voltage V_{GS} of the access NMOS transistors for the unselected cells is kept lower than their threshold voltage Vt. In other words, the SNM_{READ} with the "negative bitline concept" is not degraded. However, the negative bitline technique requires one of the bitlines WBL, WBL\ to be negatively pre-charged. This increases the risk of forward biasing PN junctions (latch-up) and puts the limit on the value of an applied negative boost. In addition, a negative supply voltage is required.

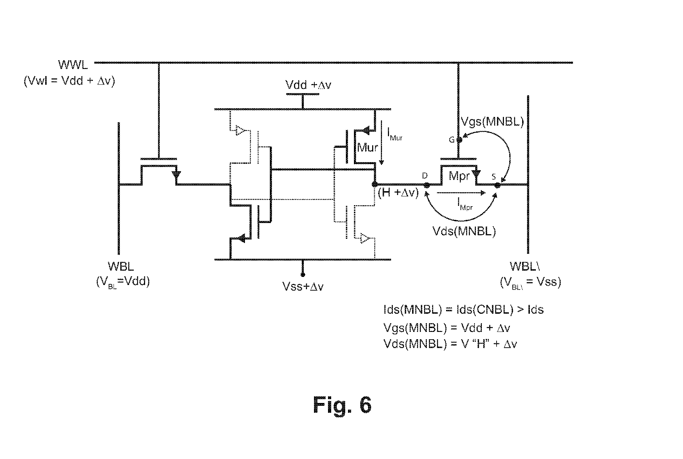

Fig 6 shows the preferred embodiment of a solution proposed by the present invention for solving the writability problem, referred to as "mimicked negative bitline", abbreviated MNBL. In the write operation for the standard 6T or 8T SRAM cell (Figs 1-3) the write_wordline voltage Vwl during a write operation is the supply voltage VDD, and the precharge voltages of the true and complement word_bitlines WBL, WBL\ are VDD and VSS (or vice versa, depending on the data to be written). In the embodiment of Fig 6, the write_bitlines WBL, WBL\ are also pre-charged to the supply and ground voltages VDD and VSS (or vice versa), but the supply and ground voltages of the selected SRAM cell, and the control voltage Vwl of the write_wordline WWL are increased to a value higher than the normal supply and ground voltages VDD, VSS. This enhances the gate-to-source V_{GS} and drain-to-source V_{DS} voltages of the NMOS access transistor Mpr, thereby increasing the discharge current IMpr. The strength of the pull-up transistors Mul, Mur does not change because the effective cell supply ((VDD+ΔV)-(VSS+ΔV)) remains unchanged. Although quite similar in many respects to the negative bitline NBL technique (hence the name "mimicked negative bitline"), an important advantage of the MNBL technique is that it avoids the risk of forward biasing PN junctions (latch-up), because the voltage with the lowest value, i.e. the global ground voltage VSS is preferably applied as the bulk voltage of the SRAM memory, whereas in the standard NBL-technique, one of the bitlines was pre-charged to a value lower than VSS. If the "divided word line" architecture is used then there is no degradation of SNMread of unselected cells in the same row, but the data retention for the unselected cells in the same column for which the voltage of the local ground node LGN is raised to the first voltage VSS_high, may still be an issue. This can be remedied by also raising the local supply voltage LSN for the unselected cells in the same column, by applying the third voltage VDD_high also to the unselected cells of the column.

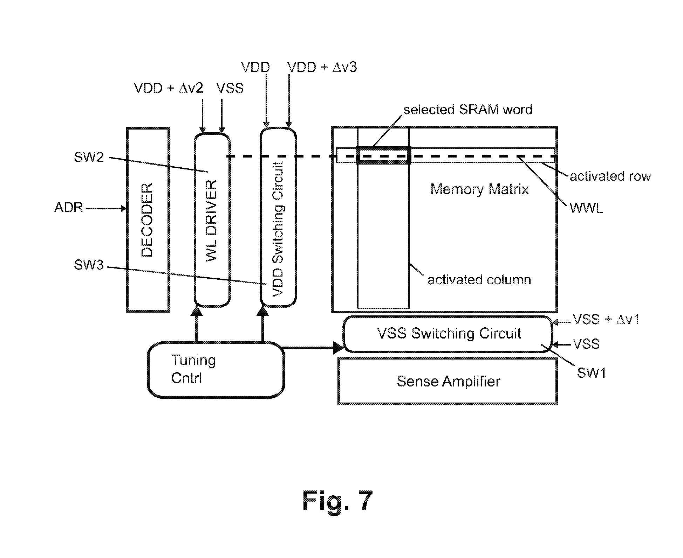

Fig 7 shows a high-level block diagram of an embodiment of the SRAM memory according to the present invention. It has a memory matrix (also known as memory array) comprising a plurality of SRAM words, each SRAM word comprising a plurality of SRAM cells. The SRAM memory of Fig 7 is organised in columns and rows, and has means for applying a global ground voltage VSS and a global supply voltage VDD to the SRAM memory, and for applying the global ground voltage VSS as bulk voltage to the SRAM memory, and data lines (not shown) for receiving data to be written, and address lines (not shown) for receiving an address for indicating the location where the data is to be written, and address decoding circuitry for selecting the SRAM word corresponding to said address, and pre-charging means for precharging one of the bitlines of the pair of complementary bitlines WBL, WBL\ of the SRAM cells of the selected SRAM word to the global ground voltage VSS, and for pre-charging the other bitline of the pair of complementary bitlines to a complementary voltage (e.g. VDD), or vice versa, depending on the data to be written in the SRAM cells of the selected SRAM word. Each row has a separate write_wordline WWL.

The SRAM word has a local ground node LGN and a local supply node LSN that can be decoupled from the global ground node VSS and the global supply node VDD. Depending on the implementation, the local ground node LGN may be connected to more than one SRAM word, e.g. to an entire column. Depending on the implementation, the local supply node LSN may be connected to more than one SRAM word, e.g. to an entire row.

The SRAM memory also has first means, e.g. ground switching circuitry containing first switching means SW1 for applying either the global ground voltage VSS or a first voltage VSS_high to the invertors of the selected SRAM word, the first voltage having a value higher than the global ground voltage VSS by a first predefined amount ΔV1 larger than zero.

The SRAM memory also has second means, e.g. worldline driver circuitry containing second switching means SW2 for applying either the global ground voltage VSS or a second voltage to the write_wordline WWL of the selected SRAM word, the second voltage having a value higher than the global supply voltage VDD by a second predefined amount Δv2 larger than zero.

The SRAM memory also has third means, e.g. supply switching circuitry containing third switching means SW3 for applying either the global supply voltage VDD or a third voltage VDD_high to the invertors of the selected SRAM word, the third voltage having a value higher than the global supply voltage VDD by a third predefined amount ΔV3 larger than zero.

The SRAM memory also has control circuitry adapted for generating control signals for controlling the first and second and third switching means SW1, SW2, SW3, such that during a write cycle to said SRAM word, the local ground node LGN is connected to the first voltage node, the write_wordline WWL is connected to the second voltage node, and the local supply node LSN is connected to the third voltage node.

In an embodiment the complementary voltage VC is the global supply voltage VDD. In an embodiment the complementary voltage VC is the third voltage VDD_high. The global supply voltage VDD as well as the third voltage may be used for pre-charging the complementary bitlines WBL, WBL\. Depending on the implementation, either can be used. Using the third voltage VDD_high helps in increasing the rise time for the internal node Q\ if so desired.

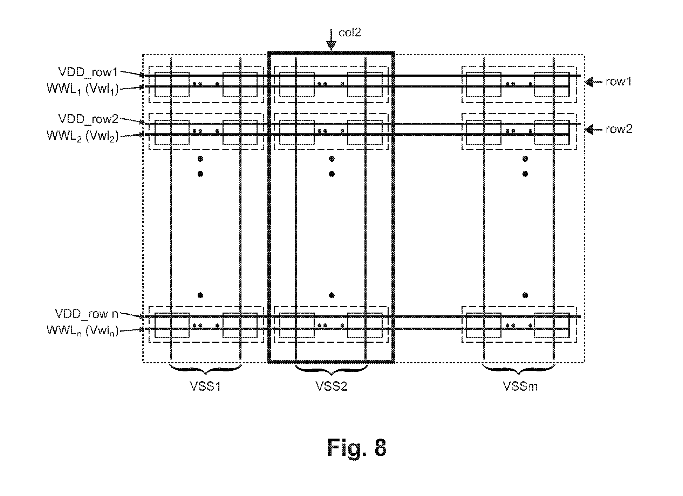

Fig 8 shows the SRAM array of Fig 7 during idle mode. The voltages applied to the local ground nodes VSS1, VSS2, ..., VSSm are all equal to the global ground voltage VSS. The voltages applied to the local supply nodes VDD_row1, VDD_row2, ... VDD_rown are all equal to the global supply voltage VDD. The voltage of each write_wordline Vwl1, Vwl2, ..., Vwln are all equal to the global ground voltage VSS.

During a read action to the SRAM word located in the second row and the second column, the local ground voltage would remain VSS, and the local supply voltage would remain VDD, but the write_wordline Vwl2 would go high to the global supply voltage VDD. In fact, that is the situation with 6T SRAM cells. For an SRAM memory having 8T SRAM cells, the write_wordline Vwl2 would remain VSS, while the read_wordline RWL would go to VDD.

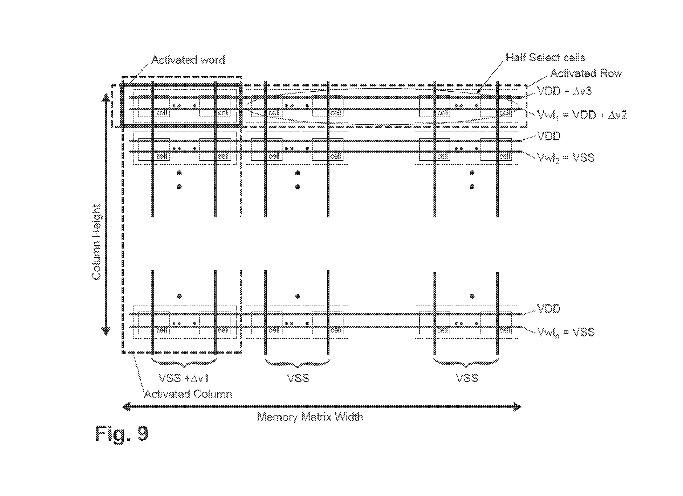

Fig 9 shows the SRAM array of Fig 7 during a write operation to the selected SRAM word, in this example located in the first column and the first row. First (not shown) the true and complement bitlines of the SRAM cells of the selected SRAM word are precharged to appropriate values, corresponding to the data to be written in the SRAM cells. Then the local ground voltage of the selected SRAM word is increased from VSS to VSS_high = VSS+Δv1, and the local supply voltage of the selected SRAM word is increased from VDD to VDD_high = VDD+Δv3, and the write_wordline WWL of the selected SRAM word is asserted by applying a voltage Vwl = VDD+Δv2 thereto.

In fact, in this example the local ground voltage of the entire column wherein the selected SRAM word is located is increased to VSS_high, and the local supply voltage of the entire row wherein the selected SRAM word is located is increased to VDD_high. This is not absolutely required however, but depends on the topology chosen. At one extreme, only the local ground and supply of the selected SRAM word may be increased, not the entire column or row, which would require minimal energy, but more silicon area. At the other extreme, the ground and supply of all the SRAM words of the entire SRAM memory may be increased, which would require minimum silicon area but large energy consumption. Changing the supply and ground voltages between the increased values VDD+ΔV, VSS+ΔV and the normal values VDD, VSS for every write cycle would involve frequent switching of huge capacitances (PMOS transistor gate-to-drain, NWELL diode capacitance of SRAM array, NMOS transistor gate-to-drain capacitance), which would increase the energy consumption and the delay for write cycles. The person skilled in the art can make an appropriate trade-off between these two extremes. The energy consumption overhead can be further reduced in software by clustering write cycles into consecutive instructions.

Although in Fig 9 some unselected SRAM words experience an increased ground voltage and/or an increased supply voltage and/or an asserted write_wordline, no write operation will occur in these unselected SRAM words, as will be explained next.

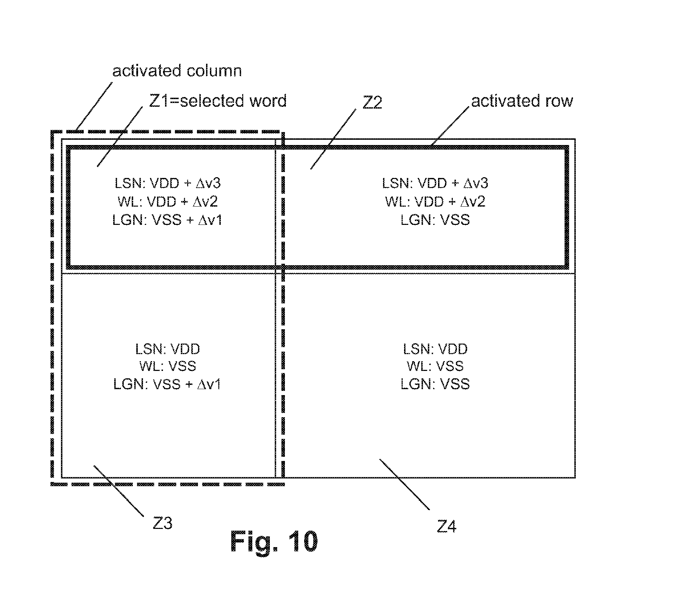

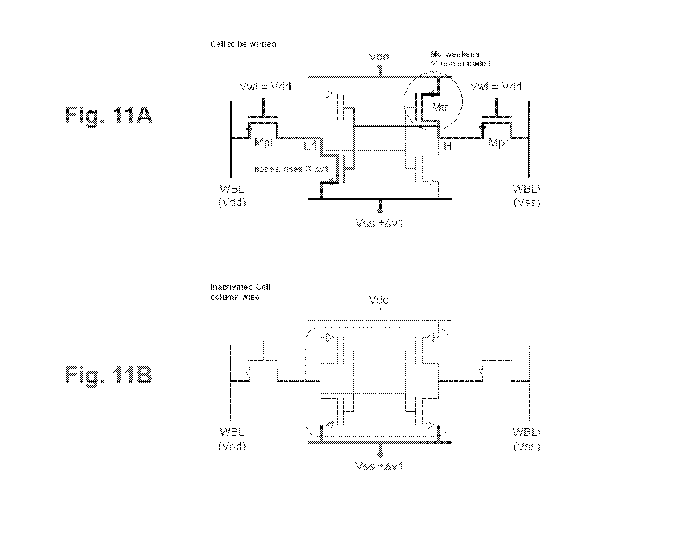

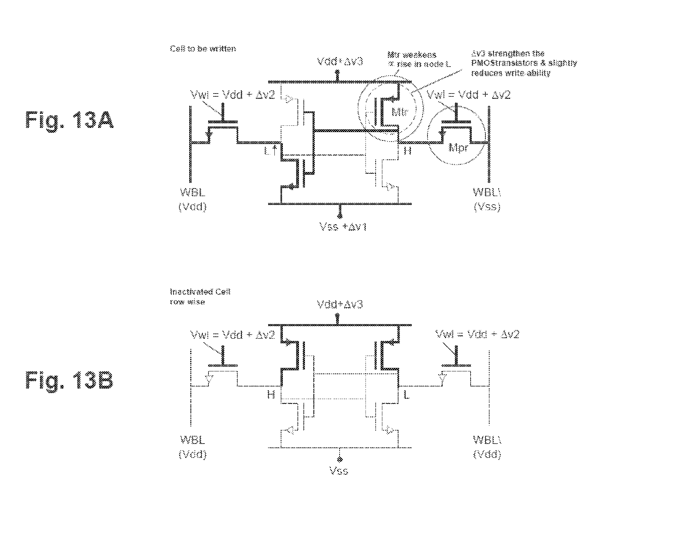

Fig 10 shows an example of the voltages applied in the different zones of the SRAM memory of Fig 9, where a first zone Z1 contains the SRAM cells of the selected SRAM word in the activated column and the activated row, a second zone Z2 contains SRAM cells in the same row as the selected SRAM word but in a different column, a third zone Z3 contains SRAM cells in the same column as the selected SRAM word but in a different row, and a fourth zone Z4 contains SRAM cells in a different row and different column. The situation of the SRAM cells in the fourth zone Z4 is the same as that of Fig 8, the situation of the SRAM cells in the third zone Z3 will be described in Fig 11B, the situation of the SRAM cells in the first zone Z1 will be described in Fig 13A, the situation of the SRAM cells in the second zone Z2 will be described in Fig 13B.

The maximum allowable value of ΔV1 is preferably limited to avoid data retention issues (i.e. stability) of inactivated cells in the activated column (Zone Z3). The maximum allowable value of ΔV2 is preferably limited by data flip issues of inactivated cells in the activated row (zone Z4). The maximum allowable value of ΔV3 is preferably limited by write-ability for the activated word. The minimum allowable value of ΔV3 is preferably limited for data flip prevention in unselected cells in the activated row.

Optionally the local supply voltage LSN of the activate column may also be raised to the third voltage VDD_high, for maintaining the level of data retention of the unselected cells in the same column.

A preferred sequence of applying the voltages is illustrated in the Figures 11A-13B, but other sequences may also be used.

Figures 11A and 11B show the effect of increasing the local ground voltage from VSS to VSS_high = VSS+Δv1, in Fig 11A for an SRAM cells of the selected SRAM word to be written, in Fig 11B for an inactivated SRAM cell in the same column as the selected SRAM word. In a first step the local ground voltage of the activated column of the memory matrix is raised by a first predefined amount Δv1. It is desirable to first increase the voltage of the local ground node because of the latency associated in changing the voltage of highly the capacitive local ground lines for the activated column. Increasing the local ground voltage from VSS to VSS+Δv1 weakens the strength of the pull-down transistor Mtr and aids in improving writability of the SRAM cell. The reduction in the strength of the pull-down transistor Mtr is proportional to the first amount Δv1. This amount is preferably limited by data retention issues of inactivated cells on the activated column (zone Z3). Fig 11A illustrates a first intermediate step for SRAM cells in zone Z1, Fig 11B illustrates the final situation of SRAM cells in zone Z3.

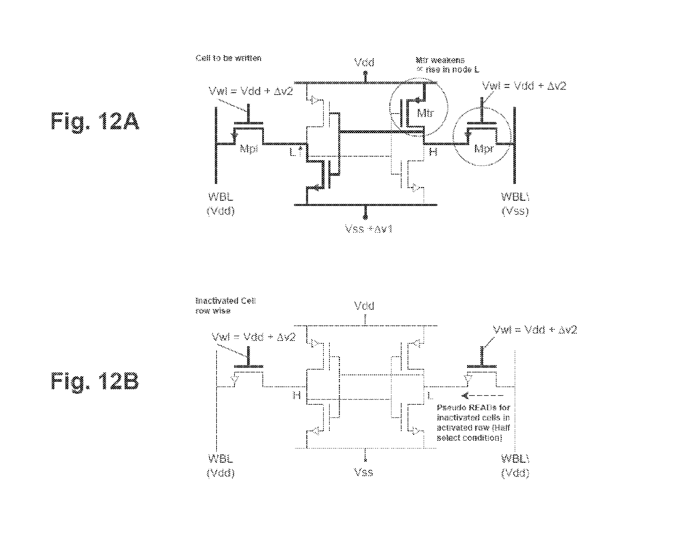

Figures 12A and 12B show the effect of subsequently increasing the write_wordline voltage Vwl, in Fig 12A for an SRAM cell to be written (zone Z1), in Fig 12B for an inactivated SRAM cell in the same row (zone Z2). In a second step the voltage of the wordline WL is increased by a second predefined amount Δv2, which increases the strength of the access transistor Mpr and thus aids in improving writability. Applying Δv1+Δv2 together results in the higher values of write margin. The higher the value of Δv2, the higher the write margin will be. But the value of WL modulation Δv2 is preferably limited by the half-select condition of the inactivated cells in an activated column. Fig 12A illustrates a second intermediate step for SRAM cells in zone Z1, Fig 12B illustrates a first intermediate step of SRAM cells in zone Z2.

Figures 13A and 13B show the effect of subsequently increasing the local supply voltage from VDD to VDD_high = VDD+Δv3, in Fig 13A for an SRAM cell to be written (zone Z1), in Fig 13B for an inactivated SRAM cell in the same row (zone Z2). In a third step the local supply voltage of the activated row is raised by a third predefined amount Δv3. Increasing the local supply voltage reduces the probability of data flips arising due to the half select condition of the inactivated cells in the activated row. However, application of Δv3 reduces the write-ability of the asserted cells by increasing the strength of the pull-up transistor Mtr. The application of Δv1 reduces the strength of the pull-up transistor Mtr (increases writability) and application of Δv3 reduces the strength of the pull-up transistor Mtr (decreases writability, but increases cell stability). Fig 13A illustrates the final situation for SRAM cells in zone Z1, Fig 13B illustrates the final situation of SRAM cells in zone Z2.

The order of step 2 and step 3 can be interchanged, depending on the scenario (if cell stability is more important or writability is more important). It is also possible to share the local supply lines of SRAM cells and the wordline drivers, in which case step 2 and step 3 occur simultaneously and the value of the second amount Δv2 is equal to the value of the third amount Δv3.

Thus, applying the first voltage higher than the global ground voltage to said ground node reduces the strength of the PMOS pull up transistor. Weakening the PMOS transistors aids in overpowering the state of the cell, which improves write-ability. Applying the second voltage higher than the value of the global supply voltage to the write-word line increases the strength of the NMOS access transistors. Strengthening the NMOS transistors aids in overpowering the state of the cell, which further improves write-ability. Applying the third voltage to said local supply node solves the problem of "half select" cells located on the same row of the SRAM cell to be written, due to the applied write_wordline voltage, and solves the data retention issue with the SRAM cells present on the same column due to the raised ground voltage.

Prior art techniques either strengthen the NMOS transistor (e.g. WL boosting, Negative BL technique) or weaken the PMOS transistor (e.g VDD-lowering or VSS-raising), but not both. In addition the value of boost applied in the prior art techniques is limited by the reduced stability of the SRAM cells on the selected row (in case of WL-boosting) or risk of latch-up (in case of negative bit-line) or data retention issue with SRAM cells present on the same column (in case of VDD lowering or VSS raising). These problems are avoided or at least reduced by applying the third voltage to said local supply node which solves the problem of "half select" cells due to the applied write_wordline voltage for SRAM cells located on the same row, and the data retention issue due to the raised ground voltage for SRAM cells located on the same column.

By applying the second voltage to the write_wordline, the gate-to-source voltage Vgs of the access transistor on the side for which the bit-line of the SRAM cell is precharged at global ground voltage for writing a "0", is increased by the second predefined amount. Due to the application of the third voltage to the local supply node, the internal node storing "H" follows the source voltage of the PMOS transistor and also becomes higher by the third predefined amount, so that the drain-to-source voltage Vds of the access transistor on the side for which the bit-line of the SRAM cell is at a global ground voltage also increases. This results in a higher drive (i.e. a lower ON-resistance) as compared to the standard 6T SRAM technology, and improves the writability of the SRAM cell.

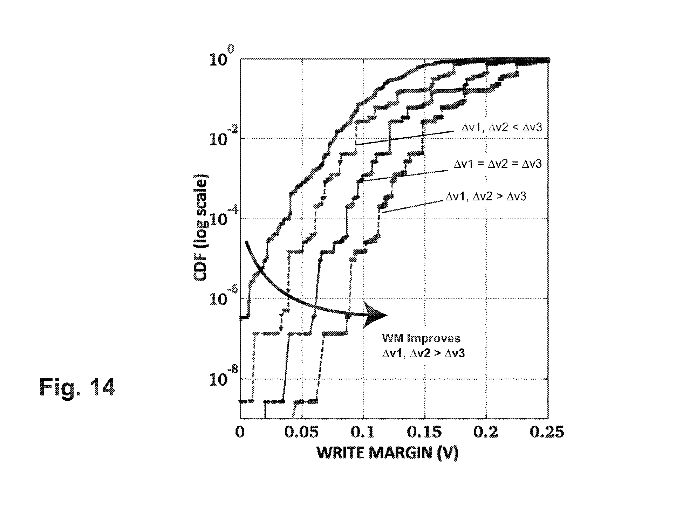

Fig 14 shows plots of the write margin (shown as a cumulative distribution function) for different values of Δv1, Δv2 and Δv3, for supply voltage VDD= 0.55V in 65nm LP technology. As can be seen, the write margin improves by increasing the first and second amounts Δv1, Δv2 with respect to the third amount Δv3.

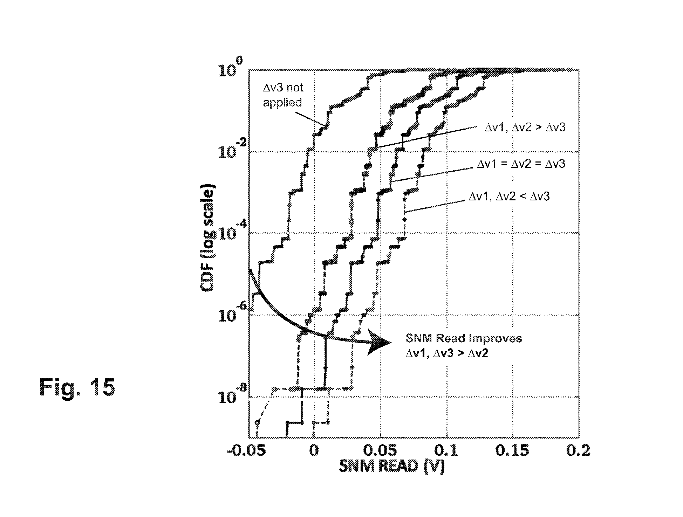

Fig 15 shows plots of the static noise margin SNM Read as an indication of cell stability, for different values of Δv1, Δv2, Δv3 for inactivated cells in activated row (zone Z2), for supply voltage VDD= 0.55V in 65nm LP technology. As can be seen from the plots, the read margin and cell stability increase when the first and second amounts are higher than the third amount.

In the particular case when the second predefined amount Δv2 equals the third predefined amount Δv3, the increase in Vds and Vgs of the access transistor is the same as in the NBL technique (in which the bit-line voltage is a predefined amount below the global ground voltage). This is how the negative bitline mechanism is mimicked, however without going below the global ground voltage VSS, thereby avoiding the risk of latch-up.

In the particular case when the first predefined amount Δv1 equals the third predefined amount Δv3, the issue of stability, i.e. data retention for the un-accessed SRAM cells present on the same column, is solved because the net difference in the local supply voltage and local ground voltage remains unchanged.

By comparing Figures 14 and 15, it is clear that an optimum value for Δv1, Δv2, Δv3 is obtained by choosing Δv1=Δv2=Δv3. In this case the MNBL technique resembles a WRITE operation using the negative bit-line (NBL) technique best.

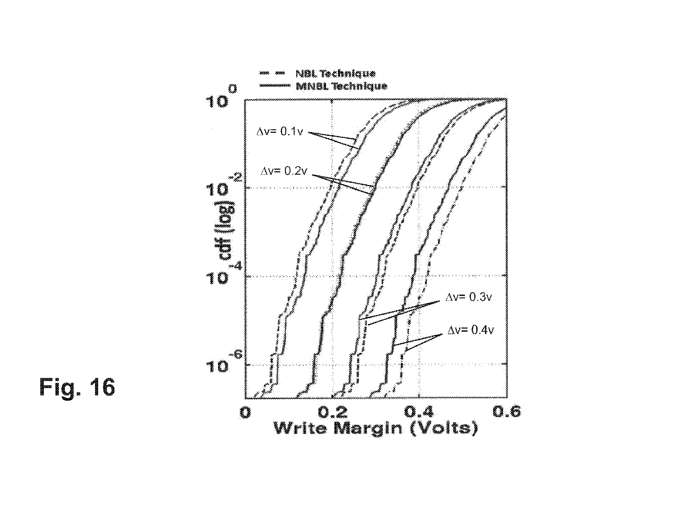

Fig 16 shows a comparison of the (simulated) performance (in terms of write margin) of the mimicked negative bitline technique (MNBL) versus the known Negative Bitline technique (NBL). As can be seen from the graphs, the performance of the MNBL technique is quite comparable to that of the NBL technique. Surprisingly, it is even better than the NBL technique for small values of ΔV (up to approximately 0.20 V for the 65nm technology node). The minor loss in performance for the higher values of ΔV (e.g. 0.20 V to 0.40 V) is due to the fact that the first voltage VSS_high with respect to the bulk-voltage VSS_Bulk applied to the SRAM memory or to the chip causes reverse body bias, resulting in an increased threshold voltage Vt of the NMOS transistors Mdl, Mdr, but the influence of reverse body bias on the threshold voltage Vt decreases with technology scaling. Besides, higher values of the difference voltage ΔV cannot be used with the NBL technique either, because of the risk of forward biasing PN junctions by applying voltages below the bulk level to the bitlines. There is no such risk involved with the MNBL technique because the bitlines are not precharged to a value below the global ground voltage VSS.

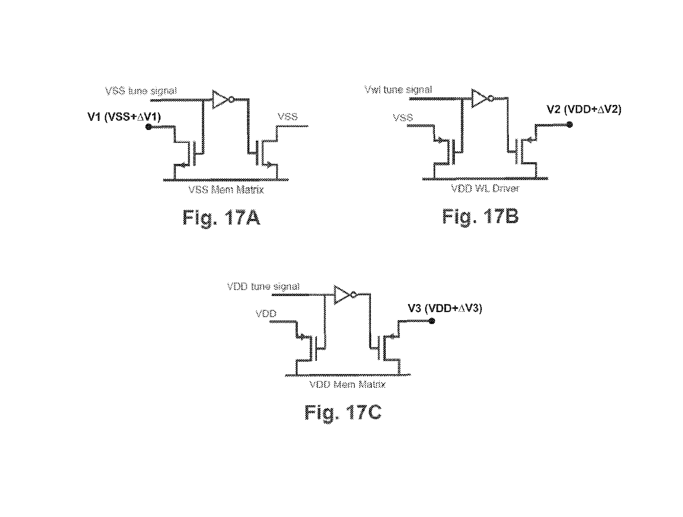

Figures 17A, 17B, 17C show an example of the first, second and third switching means SW1, SW2, SW3 respectively. The switches are controlled by control signals VSS tune, Vwl tune, VDD tune, generated in a control circuit (not shown). Such switches may e.g. be present in the VSS switching circuit block, and VDD switching circuit block, and WL driver block of Fig 7.

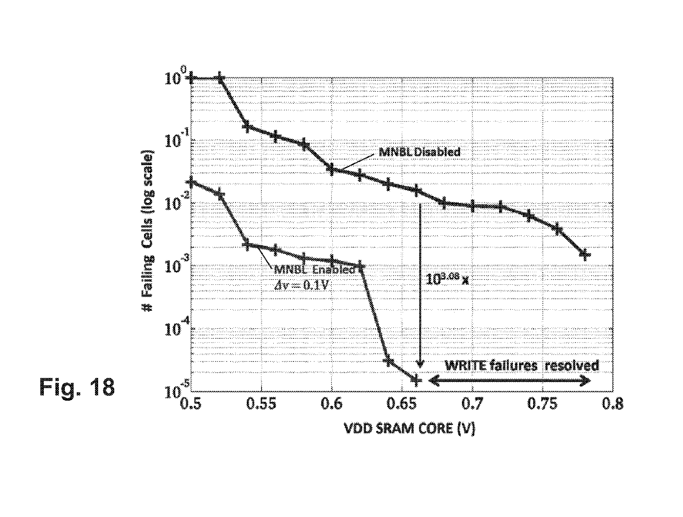

Fig 18 shows the improvement of the write margin obtained by the MNBL technique according to the preferred embodiment of the present invention, for a predefined amount of 0.10 V. As can be seen, this results in a factor thousand reduction of write failures for a global supply voltage VDD of 0.65 V.

The invention also relates to an electronic device, e.g. a system-on-chip (SoC) device for a portable application, e.g. wireless sensor nodes, or in stand-alone SRAM memory devices.

In an embodiment such electronic device comprises at least one local voltage generator for generating one of the voltages selected from the group of: the first voltage VSS_high, the global supply voltage VDD and the third voltage VDD_high. In this way less external voltages need to be supplied to the electronic device.

In an embodiment such electronic device comprises at least two local voltage generators for generating two of the voltages selected from the group of: the first voltage VSS_high, the global supply voltage VDD and the third voltage VDD_high. Such a device (chip) needs only one external supply, e.g. a battery, requires less pins, less external components on the PCB, and may occupy less board space. In an example, an external third voltage VDD_high of 0.75 V w.r.t. a global ground VSS is provided to the electronic device, and the first voltage VSS_high of 0.10 V and the global supply voltage of 0.65 V are generated internally using known DC-DC-convertor-techniques. Note that "generated internally" does not mean that all components (such as inductors or capacitors) need to be inside the chip, but it means that these voltages need not be applied from the outside. In another example, an external global voltage VDD of 0.65 V w.r.t. a global ground VSS is provided to the electronic device, and the first voltage VSS_high of 0.10 V and the third voltage of 0.75 V are generated internally.

### REFERENCES

[1] S.Cosemans, W.Dehaene, F.Catthoor, "A 3.6pJ/Access 480MHz, 128kbit On-Chip SRAM with 850MHz Boost Mode in 90nm CMOS with Tunable Sense Amplifiers," IEEE J.Solid State Circuits, pp 2065-2077, July 2009.
[2] Shibata et al., "A 0.5V 25MHz 1-mW 256Kb MTCMOS/SOI SRAM for Solar-Power-Operated Portable Personal Digital Equipment -Sure Write Operation by Using Step-Down Negatively Overhead Bitline Scheme", IEEE J.Solid-State Circuits pp. 728-742, March 2006.
[3] M.Yamaoka et al., "Low-Power Embedded SRAM Modules with Expanded Margins for Writing", ISSCC Dig. Tech. Papers, pp 480-481, Feb 2005
[4] Yamaoka M et al., " A 300 MHz 25uA/Mb Leakage On-Chip SRAM Module Featuring Process-Variation Immunity and Low-Leakage-Active Mode for Mobile-Phone Application Processor" in IEEE ISSCC, Feb 2004, pp. 494-495.

## Claims

1. Method for writing a bit-value in at least one SRAM cell, part of an SRAM memory, the SRAM cell comprising a pair of cross-coupled invertors (INV1, INV2) for storing the bit-value, the invertors (INV1, INV2) being connected between a local ground node (LGN) and a local supply node (LSN), each invertor being connected via its input to one of a pair of complementary bitlines (WBL, WBL\) via one of a pair of access transistors (Mpl, Mpr) for writing the bit-value in the SRAM cell, the pair of access transistors being controllable by a write_wordline (WWL), the method comprising the step of:
a) applying a global supply voltage (VDD) and a global ground voltage (VSS) to the SRAM memory;
b) pre-charging one of the bitlines of the pair of complementary bitlines (WBL, WBL\) to the global ground voltage (VSS), and pre-charging the other bitline of the pair of complementary bitlines to a complementary voltage (VC), depending on the bit-value to be written in the SRAM cell;
c) providing a first voltage (VSS_high) to said local ground node (LGN), the first voltage having a value higher than the value of the global ground voltage (VSS) by a first predefined amount (ΔV1);
d) applying a second voltage (VDD_WL) to the write_wordline (WWL), the second voltage having a value higher than the value of the global supply voltage (VDD) by a second predefined amount (ΔV2);
e) applying a third voltage (VDD_high) to said local supply node (LSN), the third voltage having a value higher than the value of the global supply voltage (VDD) by a third predefined amount (ΔV3).

2. The method according to claim 1, wherein the first amount (ΔV1) is equal to or higher than the third amount (ΔV3) and the second amount (ΔV2) is equal to or higher than the third amount (ΔV3).

3. The method according to claim 1 or 2, wherein step c) comprises decoupling the local ground node (LGN) from the global ground voltage (VSS), and coupling the local ground node (LGN) to a first voltage node (V1) to which the first voltage (VSS_high) is applied.

4. The method according to any one of the preceding claims, wherein step e) comprises decoupling the local supply node (LSN) from the global supply voltage (VDD), and coupling the local supply node (LSN) to a third voltage node (V3) to which the third voltage (VDD_high) is applied.

5. The method according to any one of the preceding claims, wherein the complementary voltage (VC) in step b) is the global supply voltage (VDD).

6. The method according to any one of the preceding claims, wherein the complementary voltage (VC) in step b) is the third voltage (VDD_high).

7. The method according to any one of the preceding claims, wherein the first and the second and the third amount (ΔV1, ΔV2, ΔV3) are substantially equal.

8. The method according to any one of the preceding claims, wherein each of the first and second and third amount (ΔV1, ΔV2, ΔV3) is a voltage in the range of 0.05V - 0.40V, preferably in the range of 0.1 0V-0.30V.

9. The method according to any one of the preceding claims, wherein the SRAM cells are grouped in SRAM words, and the SRAM words are arranged in rows of SRAM cells sharing the write_wordline (WWL), and in columns of SRAM cells sharing the pair of bitlines (BL, BL\), and wherein the first voltage (VSS_high) is applied only to the column, and the second and third voltage (VDD_WL, VDD_high) are applied only to the row containing the SRAM word which is to be written.

10. An SRAM memory comprising:
- a plurality of SRAM cells, each SRAM cell comprising a pair of cross-coupled invertors (INV1, INV2) for storing a bit-value, the invertors being connected between a local ground node (LGN) and a local supply node (LSN), each invertor being connected via its input to one of a pair of complementary bitlines (WBL, WBL\) via one of a pair of access transistors (Mpl, Mpr) for writing the bit-value in the SRAM cell, the pair of access transistors being controllable by a write_wordline (WWL);
- source voltage applying means for applying a global ground voltage (VSS) and a global supply voltage (VDD) to the SRAM memory;
- precharging means for precharging one of the bitlines of the pair of complementary bitlines (WBL, WBL\) of the SRAM cell to the global ground voltage (VSS), and for precharging the other bitline of the pair of complementary bitlines to a complementary voltage (VC), depending on the bit-value to be written in the SRAM cell;
- first means for applying a first voltage (VSS_high) to said local ground node (LGN), the first voltage having a value higher (VSS_high) than the value of the global ground voltage (VSS) by a first predefined amount (ΔV1);
- second means for applying a second voltage to said write_wordline (WWL) for enabling its pair of access transistors (Mpl, Mpr), the second voltage having a value (VDD_WL) higher than the value of the global supply voltage (VDD) by a second predefined amount (ΔV2);
- third means for applying a third voltage to said local supply node (LSN), the third voltage having a value (VDD_high) higher than the value of the global supply voltage (VDD) by a third predefined amount (ΔV3).

11. The SRAM memory according to claim 9, wherein the first amount (ΔV1) is equal to or higher than the third amount (ΔV3) and the second amount (ΔV2) is equal to or higher than the third amount (ΔV3).

12. The SRAM memory according to claim 10 or 11, wherein:
- the first means comprise first switching means (SW1) for disconnecting the local ground node (LGN) of said SRAM cell from the global ground voltage (VSS) and for connecting the local ground node (LGN) to a first voltage node (V1) to which the first voltage value (VSS_high) is applied;
- the second means comprise second switching means (SW2) for connecting the write_wordline (WWL) of the SRAM cell to a second voltage node (V2) to which the second voltage value (VDD_WL) is applied;
- the third means are third switching means (SW3) for disconnecting the local supply node (LSN) of said SRAM cell from the global supply voltage (VDD) and for connecting said local supply node (LSN) to a third voltage node (V3) to which the third voltage value (VDD_high) is applied.

13. The SRAM memory according to claim 12, further comprising control circuitry adapted for generating control signals (VSS tune, Vwl tune, VDD tune) for controlling the first and second and third switching means (SW1, SW2, SW3), such that during a write cycle to said SRAM cell, the local ground node (LGN) is connected to the first voltage node (V1), the write_wordline (WWL) is connected to the second voltage node (V2), and the local supply node (LSN) is connected to the third voltage node (V3).

14. The SRAM memory according to claim 12 or 13, wherein the second voltage node (V2) is the same as the third voltage node (V3).

15. The SRAM memory according to any one of the claims 10-14, wherein each SRAM cell is a 6T SRAM cell.

16. The SRAM memory according to any one of the claims 10-14, wherein each SRAM cell is an 8T SRAM cell.

17. The SRAM memory according to any one of the claims 10-16, wherein the SRAM cells are grouped in SRAM words, and the SRAM words are arranged in rows of SRAM cells sharing the write_wordline (WWL) and in columns of SRAM cells sharing the pair of complementary bitlines (WBL, WBL\) and sharing the local ground node (LGN), and wherein the first switching means (SW1) is adapted for applying the first voltage (VSS_high) to the column, and the second switching means (SW2) is adapted for applying the second voltage (VDD_WL) to the row of the SRAM word to be written, and the third switching means (SW3) is adapted for applying the third voltage (VDD_high) to the row and/or column of the SRAM word to be written.

18. An electronic device comprising the SRAM memory according to any one of the claims 10-17, and further comprising at least one local voltage generator for generating one of the voltages selected from the group of: the first voltage (VSS_high), the global supply voltage (VDD) and the third voltage (VDD_high).
